(19) Europäisches Patentamt
European Patent Office
Office européen des brevets

(11) **EP 4 119 954 B1**

(12) **EUROPEAN PATENT SPECIFICATION**

(45) Date of publication and mention
of the grant of the patent:
**12.02.2025 Bulletin 2025/07**

(21) Application number: **21185847.7**

(22) Date of filing: **15.07.2021**

(51) International Patent Classification (IPC):
**G01R 27/28** $^{(2006.01)}$    **G01R 23/16** $^{(2006.01)}$

(52) Cooperative Patent Classification (CPC):
**G01R 27/28; G01R 23/16**

(54) **MEASUREMENT SYSTEM**

MESSSYSTEM

SYSTÈME DE MESURE

(84) Designated Contracting States:
**AL AT BE BG CY CZ DE DK EE ES FI FR GB GR
HR HU IS IT LT LU LV MC MK MT NL NO PL PT RO
RS SE SI SK SM TR**

(43) Date of publication of application:
**18.01.2023 Bulletin 2023/03**

(73) Proprietor: **Rohde & Schwarz GmbH & Co. KG
81671 München (DE)**

(72) Inventors:
• **Ruengeler, Matthias
81671 München (DE)**
• **Feldhaus, Gregor
81671 München (DE)**

(74) Representative: **Novagraaf Group
Chemin de l'Echo 3
1213 Onex / Geneva (CH)**

(56) References cited:
**EP-A2- 0 841 569      US-A1- 2005 213 689
US-A1- 2012 020 397**

**Description**

The invention relates to a measurement system for determining a frequency response of a device under test.

Test and measurement instruments are used to test and analyze electronic and electrical devices by processing signals that are provided by the device to be tested. Different test and measurement instruments are known that are used for different testing purposes with regard to the characterization of the respective device. Generally, the test and measurement instrument may be a vector network analyzer, an oscilloscope, a spectrum analyzer and/or any further equipment used for testing purposes.

To ensure proper functionality of the test and measurement instrument, the respective test and measurement instrument has to be calibrated in order to ensure that the tests and analyses performed by the test and measurement instrument provide accurate results. Hence, it is important to know the amplitude and phase response of a measurement channel of the test and measurement instrument in order to characterize the influence of the measurement channel when using the test and measurement instrument for testing purposes. The amplitude and phase response is also referred to (complex) frequency response since the frequency response is a measure of magnitude and phase of an output signal as a function of frequency. In other words, the complex frequency response is associated with the amplitude response and the phase response.

In the state of the art, several different techniques are typically used for measuring the complex frequency response. However, with the techniques known, a wideband calibration signal corresponding to a low spectral power density signal requires many samples which results in a long processing time.

Thus, wideband and high speed calibration is not feasible at the moment with the techniques known, particularly when doing a frequency converting measurement, e.g. by means of a vector network analyzer.

US 2012/0020397 A1 shows a reconfigurable synthetic instrument unit that is capable of determining a frequency spectrum of an input signal by means of a Fast Fourier transform (FFT).

In EP 0 841 569 A2, a spectrum analyzer is shown that comprises a frequency shifter for shifting digital samples obtained by an analog-to-digital converter (ADC) that is located upstream of the frequency shifter.

US 2005/0213689 A1 shows a demodulator circuit built in a single semiconductor chip, which is constructed to demodulate a received OFDM-modulated packet signal.

Accordingly, there is a need for a measurement system that is enabled to perform a fast and accurate calibration over a wide frequency range.

The invention provides a measurement system for determining a frequency response of a device under test, for instance a test and measurement instrument. The measurement system comprises a signal source that is configured to provide a repetitive signal with a repetition frequency. The measurement system also comprises an analog to digital converter that is configured to convert the repetitive signal into digital samples by using a sampling rate. In addition, the measurement system has a numerically controlled oscillator and a mixing stage, wherein the numerically controlled oscillator and the mixing stage together are configured to frequency shift the samples. Further, the measurement system comprises a periodic averaging circuit that is located downstream of the numerically controlled oscillator and the mixing stage, wherein the periodic averaging circuit is configured to sum or average the samples obtained over a defined number of buffer lengths, thereby providing at least one output signal, wherein the buffer length is derived from the repetition frequency and the sampling rate. The buffer length relates to an integer multiple of the period length of the repetitive signal. Moreover, the measurement system comprises a processing circuit that is configured to perform Fourier transform on the at least one output signal, thereby converting the at least one output signal to frequency domain. The numerically controlled oscillator together with the mixing stage are configured to shift the frequency of the samples such that picket signal portions of the at least one output signal, namely the samples contained in the output signal provided by the periodic averaging circuit, are shifted to an intermediate frequency (IF) of zero, thereby ensuring that the picket signal portions, processed by the processing circuit, are associated with frequency bins in the frequency domain.

The invention is based on the finding that a fast and accurate calibration over a wide frequency range, namely up to 100 GHz, can be done since the numerically controlled oscillator and the periodic averaging circuit (in hardware) are used. The periodic averaging circuit (in hardware) improves the signal-to-noise ratio (SNR) for the periodic signal, namely the repetitive signal having the repetition frequency.

With the Fourier transform obtained, the frequency response of the device under test can be determined. Thus, the processing circuit that performs the Fourier transform on the at least one output signal provided by the periodic averaging circuit (in hardware) may be used for determining the frequency response of the device under test.

In any case, it is ensured that a real-time frequency response determination can be done, which may be used for a subsequent real-time calibration of the device under test. Accordingly, the measurement system can be used for wideband calibration and/or accurate estimation of a frequency response of the device under test. In fact, this depends on the respective purpose of the measurement system when interacting with the device under test.

In fact, the samples provided may relate to IQ samples, namely in-phase and quadrature-phase samples. Since the periodic averaging circuit is provided in hardware, it is ensured that a real-time averaging can be performed by means of the respective circuit, thereby improving the entire speed of the measurement system. In general, the measurement system may be used for determining a frequency response of the device under test. However, the measurement system according to the invention may also be used for calibrating the device under test, e.g. a test and measurement instrument.

The numerically controlled oscillator together with the mixing stage ensure that the periodic averaging circuit (in hardware), which is located downstream of these components, receives the samples in an optimized manner with regard to their frequency since the periodic averaging circuited (in hardware) processes the several samples such that a lower number of samples is forwarded to the processing circuit that performs the Fourier transform on the lower number of samples contained in the at least one output signal. Therefore, only a few frequency points are forwarded to the processing circuit for performing the Fourier transform such that it is important that these frequency points will exactly fall on the respective frequency bins of the Fourier transform. This is ensured by means of the numerically controlled oscillator together with the mixing stage which perform the frequency shift of the samples prior to the processing of the samples by means of the periodic averaging circuit (in hardware).

Accordingly, the numerically controlled oscillator together with the mixing stage are configured to take the so called picket fence effect into account that applies on the Fourier transform spectrum which is a discrete spectrum that consists of estimates of what the spectral level is at specific frequencies. Again, these specific frequencies correspond to the reduced number of samples provided by the periodic averaging circuit (in hardware) such that it is important that the few samples forwarded to the processing circuit are aligned with the respective frequency bins of the Fourier transform, thereby improving the accuracy when processing the Fourier transform at a later stage, for instance for determining the frequency response or rather calibrating the test and measurement instrument accordingly.

In fact, the picket fence effect means in general that the peaks in a Fourier transform spectrum will be measured too low in level and the valleys will be measured too high due to the picket fence effect that occurs when performing the Fourier transform. Thus, the respective samples are shifted in frequency in order to reduce the picket fence effect appropriately, thereby improving the accuracy.

The periodic averaging circuit (in hardware) located downstream of the numerically controlled oscillator and the mixing stage is configured to look at the respective frequencies of the picket signal portions. In fact, the periodic averaging circuit in hardware relates to a periodic averaging circuit.

Accordingly, the numerically controlled oscillator together with the mixing stage are configured to shift the frequency of the samples such that the picket signal portions of the at least one output signal, namely the samples contained in the output signal provided by the periodic averaging circuit in hardware, are shifted to an intermediate frequency (IF) of zero. This ensures that the picket signal portions are located in the frequency bins of the Fourier transform.

The periodic averaging circuit in hardware may sum the samples received and divide the sum obtained by the number of samples, thereby averaging the samples obtained. These steps may be formed in hardware completely. Alternatively, the periodic averaging circuit in hardware may only sum the respective samples obtained, thereby obtaining a sum that is forwarded. Hence, the respective division necessary for averaging purposes is done by means of a central processing unit (CPU) connected with the periodic averaging circuit in hardware.

Generally, the summing or rather averaging may be done in Cartesian coordinates.

The repetitive signal may relate to a periodic signal that may correspond to a baseband Dirac comb signal, a baseband rectangular signal, a mixed-up comb signal, a mixed-up rectangular signal, an arbitrary signal that is repetitively played in baseband, an arbitrary signal mixed up, e.g. WLAN signal, a Code Division Multiple Access (CDMA) signal, or rather a local oscillator signal that is up-mixed with an arbitrary signal, thereby providing the repetitive signal.

Generally, the device under test may relate to a test and measurement instrument, e.g. a (vector) network analyzer, an oscilloscope, a spectrum analyzer, a communication tester, a spectrum monitor or any further equipment used for testing purposes, particularly an instrument having or rather measuring a frequency response. However, the device under test may also relate to as a fixture or cable that is used in a measurement setup.

Accordingly, the measurement system ensures to determine the (complex) frequency response of the device under test such that this information can be used for characterizing the respective device under test, particularly for calibrating the device under test. In fact, the calibration may relate to a self-calibration of the test and measurement instrument, a calibration of a measurement setup including the respective test and measurement instrument and/or the calibration of separate devices that might be encompassed in the measurement setup.

The buffer length relates to an integer number of samples, namely an integer multiple of the period length of the repetitive signal.

For instance, the buffer length corresponds to a certain number of averages, wherein each average is based on an integer number of samples, e.g. 1,000 samples. The number of averages for one buffer length, namely the number of averaged samples for a single buffer length, may correspond to 100, resulting in 100,000 samples.

Moreover, several buffer lengths may be acquired in row within one capture, also called capture time. For instance 10 buffer lengths are acquired in row within one capture, resulting in 10x 100,000 samples in total. Since these buffer lengths are acquired in row, no group delay alignment is necessary.

Furthermore, several captures (potentially non-triggered) may be gathered, e.g. 20 captures, which require a group delay alignment. Thus, the number of captures influence the overall measurement time.

As mentioned above, the averaging is done after the numerically controlled oscillator which is important since the averaging together with the subsequent Fourier transform provide only a few frequency points. Thus, the picket signal portions, e.g. the comb lines of the repetitive signal, have to exactly fall on the frequency bins, also called Fourier transform bins or rather FFT bins in case of a Fast Fourier transform (FFT). This is ensured by means of the numerically controlled oscillator and the associated mixing stage which are located in front of the periodic averaging circuit in hardware, namely upstream.

Generally, the repetition frequency corresponds to the frequency rate of the repetitive signal that has certain signal portions that repeat periodically, yielding the repetitive signal.

An aspect provides that the periodic averaging circuit in hardware is configured to provide the at least one output signal in real-time and/or to perform IQ averaging. Since the periodic averaging circuit is established by hardware means, the respective processing can be done in real time, thereby improving the speed of the measurement system. The periodic averaging circuit in hardware is configured to do live averaging, the frequency response can be determined quickly, particularly in real-time, even though the signal has a somewhat poor signal-to-noise ratio. As mentioned above, the samples provided may relate to IQ samples such that the periodic averaging circuit in hardware performs the IQ averaging.

Another aspect provides that the periodic averaging circuit in hardware is established by field-programmable gate array (FPGA) or a digital signal processor (DSP). Hence, real-time capable hardware is used for implementing the periodic averaging circuit in hardware.

Another aspect provides that the measurement system further comprises a fractional resampler that is located upstream of the periodic averaging circuit in hardware. The fractional resampler is configured to provide an integer number of samples that corresponds to a repetition length of the repetitive signal. The fractional resampler ensures that the integer number of samples provided corresponds to the repetition length of the repetitive signal such that it is always possible to meet the requirement that the buffer length corresponds to an integer multiple, also for odd repetition frequencies and sample rates. In fact, the fractional resampler is located in front of the periodic averaging circuit in hardware in order to ensure that the periodic averaging circuit in hardware receives the integer number of samples.

The fractional resampler may be located upstream of the numerically controlled oscillator or rather downstream of the numerically controlled oscillator. In other words, the relative orientation of the fractional resampler and the numerically controlled oscillator is arbitrary. Hence, the fractional resampler and the numerically controlled oscillator can be in any order (with respect to each other). However, both the fractional resampler and the numerically controlled oscillator are located upstream of the periodic averaging circuit in hardware.

In fact, the resampler receiving the samples before they are forwarded to the periodic averaging circuit in hardware is configured to resample the samples received, thereby ensuring that the samples outputted relates to the integer number of samples that corresponds to the repetition length of the repetitive signal.

Further, the measurement system may comprise a frequency reference that is connected with the signal source and the analog to digital converter, thereby providing a common frequency reference for the signal source and the analog to digital converter. Thus, the analog to digital converter and the signal source can be aligned with respect to each other. In fact, this ensures to couple a clock of the analog to digital converter to the repetition frequency or rather repetition rate of the signal source, resulting in a coherent rates, namely coherence of the repetition rate and the sampling rate.

In a free running system, the repetition frequency and/or the sampling rate may be estimated, in particular wherein the estimated repetition frequency and/or the estimated sampling rate are/is forwarded to the fractional resampler. The free running system means that the repetition rate or rather repetition frequency of the repetitive signal is not coupled to the clock of the analog to digital converter, which may yield to a non-coherent repetition frequency, as the signal source is not tied to the sampling rate. Therefore, it is necessary to perform an estimation on the estimated repetition frequency and/or the sampling rate, wherein the respective information is forwarded to the respective components of the measurement system in order to compensate for the offset. In fact, the fractional resampler may adapt its resampling rate accordingly.

Furthermore, the periodic averaging circuit in hardware may be configured to determine number of averages based on signal-to-noise ratio (SNR) and resolution bandwidth (RBW). As indicated above, the buffer length comprises a certain number of averages, wherein the specific number depends on the signal-to-noise ratio (SNR) and the resolution bandwidth (RBW).

Usually, the resolution bandwidth may be left unchanged wherein the signal-to-noise ratio will be improved by adapting the number of averages that are necessary to obtain the respective aim, namely the improvement of the signal-to-noise ratio (SNR).

For instance, the resolution bandwidth (RBW) may be set, but the number of averages samples may be varied, namely the number of averages.

A further aspect provides that the periodic averaging circuit in hardware is configured to output several averaged signals. Particularly, the several averaged signals may be associated each with the defined number of buffer lengths. The several averaged signals may relate to consecutive input samples such that they relate to a certain capture comprising the several averaged signals.

Alternatively, the input samples may be triggered such that the several averaged signals are not associated with consecutive input samples. In fact, an averaged signal may be started by each trigger event.

The several averaged signals may also relate to several captures, wherein each capture comprises several buffer lengths, particularly several buffer lengths of consecutive input samples.

The measurement system may be configured to compensate for a group delay. Additionally or alternatively, the measurement system is configured to average again in polar coordinates. Particularly, the additional averaging is done after a group delay compensation. As mentioned above, several captures may be provided that are untriggered such that a group delay compensation is necessary. Moreover, a free running system may be provided as indicated above, which may also require a group delay compensation. In any case, a group delay calculator may be provided that determines the respective group delay, wherein the group delay determined is used by a compensation module that is configured to perform the group delay compensation afterwards.

The processing circuit may determine the frequency responses based on the Fourier transforms obtained, wherein the frequency responses may be averaged again in polar coordinates afterwards, namely after the group compensation. In fact, the additional averaging may be done for the phase and amplitude separately. This averaging may also be done by hardware means, e.g. an FPGA, a DSP or rather firmware.

The measurement system may comprise a windowing circuit that is configured to perform a windowing multiplication with a known window. The windowing circuit is located either before or after the periodic averaging circuit in hardware. Accordingly, the known window is multiplied with the samples forwarded to the periodic averaging circuit in hardware or rather with the at least one output signal outputted by the periodic averaging circuit in hardware. In any case, the resolution bandwidth (RBW) can be controlled easily by applying the windowing, particularly a windowing combined with a certain overlap.

Another aspect provides that the measurement system comprises multiple channels, wherein the measurement system is configured to determine relative frequency responses of the signals processed by the multiple channels. As mentioned above, the measurement system is enabled to determine the frequency response for the signal processed accordingly by taking the Fourier transform into account. The multiple channels each process a corresponding signal such that the measurement system is enabled to determine the respective frequency responses of each of the signals processed by the different channels. Therefore, the measurement system is also enabled to determine the relative frequency responses of the signals processed by the respective channels.

In addition, the measurement system may comprise an equalizer module that is configured to calculate a compensating digital filter for frequency response determined and to apply the compensating digital filter. The equalization ensures that a calibration of the device under test may be done appropriately.

Further, the measurement system may comprise a local oscillator, wherein an offset determination circuit is provided, which is configured to determine a phase offset of the local oscillator with respect to the start phase of the repetitive signal, and wherein the phase of the local oscillator is corrected. The local oscillator may be associated with the signal source. The local oscillator may be used for up-mixing a signal, e.g. an arbitrary signal, in order to generate the repetitive signal. A phase offset of the local oscillator may be compensated appropriately by using the offset determination circuit. In fact, the local oscillator start phase may be estimated or rather determined such that the local oscillator phase offset can be corrected accordingly.

Generally, the phase offset may be compensated in the local oscillator or also in the numerically controlled oscillator.

The repetition frequency may be an estimated repetition frequency that is estimated by means of an estimator module or a known repetition frequency. Particularly, the repetition frequency is retrieved from a data base or inputted by an operator of the measurement system such that the repetition frequency is a known one. Alternatively, the estimator module may be provided that is configured to estimate the repetition frequency in frequency domain. Thus, the estimator module may take the output of the processing circuit into account in order to estimate the repetition frequency by analyzing the Fourier transform accordingly.

Further, the signal source may be established by the device under test itself or a calibration signal generator.

In general, the main idea of the measurement system is to perform a real-time averaging before performing the Fourier transform.

The forgoing aspects and many of the attendant advantages of the claimed subject matter will become more readily appreciated as the same become better understood by reference to the following detailed description, when taken in conjunction with the accompanying drawings, wherein:

- Figure 1 schematically shows an overview of a measurement system according to the invention, and

- Figure 2 schematically shows an overview of different repetitive signals.

The detailed description set forth below in connection with the appended drawings, where like numerals reference like elements, is intended as a description of various embodiments of the disclosed subject matter and is not intended to represent the only embodiments. Each embodiment described in this disclosure is provided merely as an example or illustration and should not be construed as preferred or advantageous over other embodiments. The illustrative examples provided herein are not intended to be exhaustive or to limit the claimed subject matter to the precise forms disclosed.

For the purposes of the present disclosure, the phrase "at least one of A, B, and C", for example, means (A), (B), (C), (A and B), (A and C), (B and C), or (A, B, and C), including all further possible permutations when more than three elements are listed. In other words, the term "at least one of A and B" generally means "A and/or B", namely "A" alone, "B" alone or "A and B".

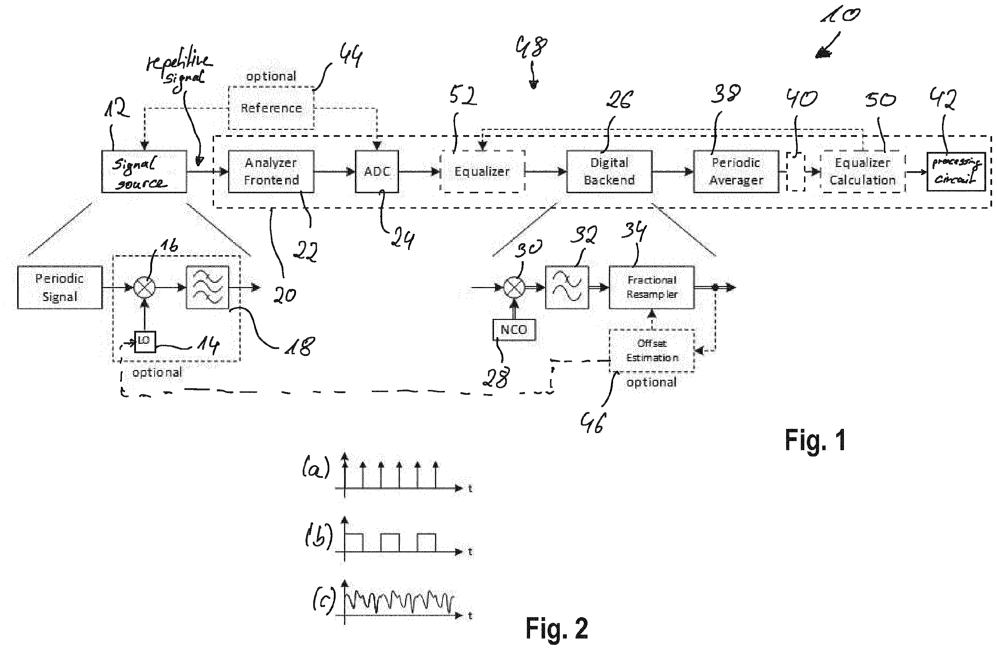

In Figure 1, a measurement system 10 is shown that can be used for determining a frequency response of a device under test, for instance for calibrating the device under test.

The measurement system 10 comprises a signal source 12 that is configured to provide a repetitive signal with a repetition frequency o rather repetition rate. The signal source 12 may be established by the device under test itself or rather a calibration signal generator.

In the shown embodiment, the signal source 12 comprises a local oscillator 14, a mixer 16 and a filter 18, e.g. a bandpass filter. The mixer 16 receives the local oscillator signal (LO signal) from the local oscillator 14 that is mixed-up with a periodic signal, e.g. an arbitrary signal repetitively played, thereby providing the repetitive signal with the repetition frequency.

Alternatively, the signal source 12 may directly provide repetitive signal with the repetition frequency. Hence, the local oscillator 14, the mixer 16 and the filter 18 are shown in the dashed box labelled with optional.

Examples of repetitive signals are shown in Figure 2 illustrating a Dirac comb signal (a), a rectangular signal (b) or rather an arbitrary signal repetitively played (c).

Generally, the signal source 12 may be established by a device under test that shall be calibrated or rather tested.

Hence, the measurement system 10 further comprises an analyzer device 20 with a frontend 22 to which the signal source 12 is connected. Hence, the repetitive signal is inputted via the frontend 22 that forwards the repetitive signal to an analog to digital converter (ADC) 24 that converts the repetitive signal into digital samples by using a sampling rate.

Particularly, in-phase and quadrature-phase samples (IQ samples) are provided for further processing.

The measurement system 10, particularly the analyzer device 20, further comprises a digital backend 26 for further processing the samples provided by the ADC 24.

The digital backend 26 comprises a numerically controlled oscillator 28, a mixing stage 30, a filter 32, e.g. a low-pass filter, and a fractional resampler 34, which will be described later in more detail. However, the digital backend 26 ensures to prepare the samples obtained for further processing by means of a subsequent stage.

The subsequent stage is established by a periodic averaging circuit in hardware 38, also called periodic averager, which is located downstream of the digital backend 26, particularly the numerically controlled oscillator 28 and the mixing stage 30.

The periodic averaging circuit in hardware 38 may be established by hardware means, for instance a field-programmable gate array (FPGA) or a digital signal processor (DSP). Thus, the periodic averaging circuit in hardware 38 is capable of real-time processing the samples obtained.

Generally, the periodic averaging circuit in hardware 38 sums or averages the samples obtained over a defined number of buffer lengths, thereby providing at least one output signal. The at least one output signal may relate to an averaged signal in case that the periodic averaging circuit in hardware 38 averages the samples obtained.

The buffer length is derived from the repetition frequency of the repetitive signal and the sampling rate of the ADC 24. Generally, the buffer length relates to an integer number of samples, namely an integer multiple of the period length of the repetitive signal.

The buffer length of the averaging done by means of the periodic averaging circuit in hardware 38 corresponds to a certain number of averages, wherein each average obtained is based on an integer number of samples, e.g. 1,000 samples. Hence, the periodic averaging circuit in hardware 38 takes an integer number of samples into account to provide the respective average, e.g. 1,000 samples.

The number of averages for one buffer length, namely the number of averaged samples for a single buffer length, may correspond to 100, resulting in 100,000 samples that are taken into account by the periodic averaging circuit in hardware 38.

In general, several buffer lengths may be acquired in row within one capture, also called capture time. Since these buffer lengths are acquired in row, no group delay alignment is necessary. However, several captures, particularly non-triggered ones, may be gathered, which require a group delay alignment, as they are not acquired in row. Irrespective thereof, the number of captures influence the overall measurement time.

The periodic averaging circuit in hardware 38 reduces the noise power of repetitive signals by averaging over a defined number of periods. This is useful for frequency response calibration with low power signals that typically have a low signal-to-noise ratio (SNR). The periodic averaging circuit in hardware 38 may average the samples by calculating in real-time

$$y(k) = \frac{1}{N} \cdot \sum_{i=0}^{N-1} x(i \cdot L + k)$$

where N is the number of periods to average and L is the period length in number of samples. Alternatively, the periodic averaging circuit in hardware 38 may only sum the samples obtained by calculating in real-time

$$y(k) = \sum_{i=0}^{N-1} x(i \cdot L + k)$$

wherein the respective division by N, namely the number of periods in number of samples, is done afterwards, e.g. by means of a subsequent central processing unit (CPU) 40. Accordingly, the overall averaging is done by means of two components, wherein each of the components do the averaging partly, namely the summing step is done by the periodic averaging circuit in hardware 38, particularly in real-time, whereas the division is done by the CPU 40.

The signal processed x(k) is a periodic signal $x_p(k)$ with additive independent noise $x_n(k)$:

$$y(k) = \frac{1}{N} \cdot \sum_{i=0}^{N-1} x_p(i \cdot L + k) + x_n(i \cdot L + k) = x_p(k) + \frac{1}{N} \cdot \sum_{i=0}^{N-1} x_n(i \cdot L + k)$$

The mean value of N independent normally distributed random variables

$$y_n = \frac{1}{N} \cdot \sum_{i=0}^{N-1} x_n(i)$$

is also normally distributed with the variance

$$\sigma_y^2 = \frac{\sigma_x^2}{N}.$$

Therefore, the noise power reduces with $10 \cdot \log_{10}(N)$ due to the averaging performed by means of the periodic averaging circuit in hardware 38 (and optionally the CPU 40).

Generally, the periodic averaging circuit in hardware 38 determines the number of averages used in dependency of the signal-to-noise ratio (SNR) and resolution bandwidth (RBW), which may be set. Hence, the number of averages may be varied in order to obtain the best SNR possible. Thus, an independent parametrization of RBW and averaging time is possible.

The at least one output signal is forwarded to a processing circuit 42 that is located downstream of the periodic averaging circuit in hardware 38.

The processing circuit 42 performs a Fourier transform on the at least one output signal, thereby obtaining the Fourier transform in the frequency domain since the at least one output signal is converted to frequency domain.

The processing circuit 42 may further analyze the Fourier transform obtained in order to determine a frequency response.

Furthermore, the processing circuit 42 may be used for performing the subsequent step of division in case that the periodic averaging circuit in hardware 38 only sums the samples obtained.

As indicated previously, the digital backend 26 is provided for preparing the samples with regard to the subsequent stages, e.g. the periodic averaging circuit in hardware 38 and the Fourier transformation done by means of the processing circuit 42.

Generally, in a Fourier transform, e.g. a Fast Fourier transform (FFT), the so-called picket fence effect occurs. The Fourier transform spectrum is a discrete one, which consists of estimates of what the spectral level is at specific frequencies, also called frequency bins. The respective frequencies or rather frequency bins are determined by the analysis parameters. In other words, they have nothing to do with the signal being analyzed. Accordingly, there may be peaks in the true spectrum of the signal that are between the lines of the Fourier transform spectrum. Accordingly, the peaks in the Fourier transform spectrum will be measured too low in level, whereas the valleys will be measured too high. Moreover, the true frequencies where the peaks and valleys lie will not be those indicated in the Fourier transform spectrum. This is called picket fence effect.

However, the digital backend 26 is used to minimize or rather to avoid this picket fence effect since the numerically controlled oscillator 28 together with the mixing stage 30 are configured to shift the frequency of the samples such that picket signal portions of the at least one output signal, processed by the processing circuit 42, are associated with the frequency bins in the frequency domain.

Accordingly, the samples are manipulated such that the picket signal portions get in the respective frequency bins in the Fourier transform spectrum obtained by the processing circuit 42. In other words, the "picket fence" or rather the samples are shifted with respect to each other due to the manipulation done by means of the numerically controlled oscillator 28 together with the mixing stage 30.

The digital backend 26 further comprises the fractional resampler 34 that is interposed between the numerically controlled oscillator 28 with the mixing stage 30 and the periodic averaging circuit in hardware 38 in the shown embodiment. However, the relative orientation of the fractional resampler 34 and the numerically controlled oscillator 28 with the mixing stage 30 may be arbitrary. Put differently, the numerically controlled oscillator 28 with the mixing stage 30 may also be located between the fractional resampler 34 and the periodic averaging circuit in hardware 38. It is only important that both modules, namely the fractional resampler 34 as well as the numerically controlled oscillator 28 with the mixing stage 30, both are located upstream of the periodic averaging circuit in hardware 38 since both modules are used to prepare the samples for being processed by the periodic averaging circuit in hardware 38.

Generally, the fractional resampler 34 processes the samples such that an integer number of samples is provided that corresponds to a repetition length of the repetitive signal. Hence, it is ensured that the periodic averaging circuit in hardware 38 receives an integer multiple of the repetition length of the repetitive signal in number of samples.

Accordingly, the digital backend 26 prepares or rather manipulates the samples obtained, namely the IQ samples, such that the periodic averaging circuit in hardware 38 is enabled to process the samples obtained, particularly performing an IQ averaging, while the subsequent processing circuit 42 that performs the Fourier transform provides a Fourier spectrum with reduced picket fence effect.

Since the averaging is done by means of the periodic averaging circuit in hardware 38, e.g. hardware means like an FPGA or a DSP, it is ensured that the at least one output signal is provided in real-time such that the frequency response can be determined quickly.

Figure 1 further shows that the measurement system 10 may comprise a frequency reference 44 that is optional. The frequency reference 44 is associated with the signal source 12 and the ADC 24, particularly the clock of the ADC 24. The frequency reference 44 provides a common frequency reference for the signal source 12 and the ADC 24 such that the sampling rate and the repetition rate are coherent with each other.

Alternatively, a so-called free running system is provided such that the repetition frequency and/or the sampling rate have to be estimated by means of an offset estimation circuit 46 that is also shown in Figure 1, particularly as being part of the digital backend 26.

The offset estimation circuit 46 is configured to estimate the repetition frequency of the repetitive signal and/or the sampling rate of the ADC 24, wherein the respective information is forwarded to the fractional resampler 34. The fractional resampler 34 may adapt its resampling rate accordingly to compensate for the offset estimated.

Moreover, the repetition frequency may also be known as being retrieved from a database or rather inputted by an operator of the measurement system 10. Hence, it is not necessary to estimate the repetition frequency of the repetitive signal.

Furthermore, the measurement system may comprise an equalizer module 48 that comprises an equalizer calculator 50 and an equalizer 52 itself, which are in communication with each other.

The equalizer calculator 50 calculates a compensating digital filter for a frequency response. Therefore, the equalizer calculator 50 is located downstream of the periodic averaging circuit in hardware 38. The equalizer calculator 50 may be located downstream of the processing circuit 42.

The equalizer calculator 50 forwards the compensating digital filter calculated to the equalizer 52 that applies the respective filter. Hence, the equalizer 52 is located upstream of the periodic averaging circuit in hardware 38, particularly upstream of the digital backend 26.

As already discussed previously, the signal source 12 may comprise the local oscillator 14 that may have an unknown local oscillator start phase at beginning of every repetition of the repetitive signal. Hence, it is necessary to estimate the local oscillator start phase which may be done by means of an offset determination circuit that determines a phase offset of the local oscillator 14 with respect to start phase of the repetitive signal, and wherein the phase of the local oscillator is corrected. The offset determination circuit may correspond to the offset estimation circuit 46.

The phase offset estimated may be compensated in the local oscillator 14 or also in the numerically controlled oscillator 28.

As already indicated above, the periodic averaging circuit in hardware 38 is enabled to output several averaged signals that are associated with the defined number of buffer lengths. The several averaged signals may relate to consecutive samples received or rather new captures due to trigger events.

In case of averaged signals obtained due to trigger events, a group delay compensation may be necessary that is done by the measurement system 10. Further, an additional average in polar coordinates after group delay compensation may be done by hardware means, particularly the FPGA or rather DSP, providing the periodic averaging circuit in hardware 38.

Even though not shown in Figure 1, the measurement system 10 may also comprise multiple channels such that several inputs are provided which may be aligned. Accordingly, relative group delay, phase and amplitude response or rather frequency response can be measured. Moreover, the measurement system 10 is enabled to determine relative frequency responses of the signals processed by the multiple channels since the frequency response for each individual signal processed by the respective channels can be determined.

In addition, the measurement system 10 may also comprise a windowing circuit that is configured to perform a windowing multiplication with a known window. This allows to control the RBW more easily.

Certain embodiments disclosed herein, particularly the respective module(s), utilize circuitry (e.g., one or more circuits) in order to implement standards, protocols, methodologies or technologies disclosed herein, operably couple two or more components, generate information, process information, analyze information, generate signals, encode/decode signals, convert signals, transmit and/or receive signals, control other devices, etc. Circuitry of any type can be used.

In an embodiment, circuitry includes, among other things, one or more computing devices such as a processor (e.g., a microprocessor), a central processing unit (CPU), a digital signal processor (DSP), an application-specific integrated circuit (ASIC), a field-programmable gate array (FPGA), a system on a chip (SoC), or the like, or any combinations thereof, and can include discrete digital or analog circuit elements or electronics, or combinations thereof. In an embodiment, circuitry includes hardware circuit implementations (e.g., implementations in analog circuitry, implementations in digital circuitry, and the like, and combinations thereof).

In an embodiment, circuitry includes combinations of circuits and computer program products having software or firmware instructions stored on one or more computer readable memories that work together to cause a device to perform one or more protocols, methodologies or technologies described herein. In an embodiment, circuitry includes circuits, such as, for example, microprocessors or portions of microprocessor, that require software, firmware, and the like for operation. In an embodiment, circuitry includes one or more processors or portions thereof and accompanying software, firmware, hardware, and the like.

The present application may reference quantities and numbers. Unless specifically stated, such quantities and numbers are not to be considered restrictive, but exemplary of the possible quantities or numbers associated with the present application. Also in this regard, the present application may use the term "plurality" to reference a quantity or number. In this regard, the term "plurality" is meant to be any number that is more than one, for example, two, three, four, five, etc. The terms "about", "approximately", "near" etc., mean plus or minus 5% of the stated value.

**Claims**

1. A measurement system for determining a frequency response of a device under test, wherein the measurement system (10) comprises

   - a signal source (12) that is configured to provide a repetitive signal with a repetition frequency,
   - an analog to digital converter (24) that is configured to convert the repetitive signal into digital samples by using a sampling rate,
   - a numerically controlled oscillator (28) and a mixing stage (30), wherein the numerically controlled oscillator (28) and the mixing stage (30) together are configured to frequency-shift the samples,
   - a periodic averaging circuit (38) that is located downstream of the numerically controlled oscillator (28) and the mixing stage (30), wherein the periodic averaging circuit (38) is configured to sum or average the samples obtained over a defined number of buffer lengths, thereby providing at least one output signal, wherein the buffer length is derived from the repetition frequency and the sampling rate, wherein the buffer length relates to an integer multiple of the period length of the repetitive signal,
   - a processing circuit (42) that is configured to perform a Fourier transform on the at least one output signal, thereby converting the at least one output signal to frequency domain, and

   wherein the numerically controlled oscillator (28) together with the mixing stage (30) are configured to shift the frequency of the samples such that picket signal portions of the at least one output signal, namely the samples contained in the output signal provided by the periodic averaging circuit (38), are shifted to an intermediate frequency (IF) of zero, thereby ensuring that the picket signal portions, processed by the processing circuit (42), are associated with frequency bins in the frequency domain.

2. The measurement system according to claim 1, wherein the periodic averaging circuit (38) is configured to provide the at least one output signal in real-time and/or to perform IQ averaging.

3. The measurement system according to claim 1 or 2, wherein the periodic averaging circuit (38) is established by a field-programmable gate array (FPGA) or a digital signal processor (DSP).

4. The measurement system according to any of the preceding claims, wherein the measurement system (10) further comprises a fractional resampler (34) that is located upstream of the periodic averaging circuit (38), wherein the fractional resampler (34) is configured to provide an integer number of samples that corresponds to a repetition length of the repetitive signal.

5. The measurement system according to any of the preceding claims, wherein the measurement system (10) comprises a frequency reference (44) that is connected with the signal source (12) and the analog to digital converter (24), thereby providing a common frequency reference for the signal source (12) and the analog to digital converter (24).

6. The measurement system according to any of the preceding claims, wherein, in a free running system, the repetition frequency and/or the sampling rate are estimated, in particular wherein the estimated repetition frequency and/or the estimated sampling rate are/is forwarded to the fractional resampler (34).

7. The measurement system according to any of the preceding claims, wherein the periodic averaging circuit (38) is configured to determine number of averages based on signal-to-noise ratio (SNR) and resolution bandwidth (RBW).

8. The measurement system according to any of the preceding claims, wherein the periodic averaging circuit (38) is configured to output several averaged signals, in particular wherein the several averaged signals each are associated with the defined number of buffer lengths.

9. The measurement system according to any of the preceding claims, wherein the measurement system (10) is configured to compensate for group delay and/or wherein the measurement system (10) is configured to average again in polar coordinates, particularly after group delay compensation.

10. The measurement system according to any of the preceding claims, wherein the measurement system (10) comprises a windowing circuit that is configured to perform a windowing multiplication with a known window, in particular wherein the windowing circuit is located either before or after the periodic averaging circuit (38).

11. The measurement system according to any of the preceding claims, wherein the measurement system (10) comprises multiple channels, wherein the measurement system (10) is enabled to determine the respective frequency responses of each of the signals processed by the different channels, and wherein the measurement system (10) is configured to determine relative frequency responses of the signals processed by the multiple channels.

12. The measurement system according to any of the preceding claims, wherein the measurement system (10) comprises an equalizer module (48) that is configured to calculate a compensating digital filter for a frequency response determined and to apply the compensating digital filter.

13. The measurement system according to any of the preceding claims, wherein the measurement system (10) comprises a local oscillator (14), wherein an offset determination circuit is provided, which is configured to determine a phase offset of the local oscillator (14) with respect to start phase of the repetitive signal, and wherein the phase of the local oscillator (14) is corrected.

14. The measurement system according to any of the preceding claims, wherein the repetition frequency is an estimated repetition frequency that is estimated by means of an estimator module (46) or a known repetition frequency, particularly retrieved from a database or inputted by an operator of the measurement system.

15. The measurement system according to any of the preceding claims, wherein the signal source is established by the device under test itself or a calibration signal generator.

**Patentansprüche**

1.  Messsystem zum Bestimmen einer Frequenzantwort einer zu testenden Vorrichtung, wobei das Messsystem (10) umfasst

    - eine Signalquelle (12), die konfiguriert ist, um ein Wiederholungssignal mit einer Wiederholungsfrequenz bereitzustellen,
    - einen Analog-Digital-Wandler (24), der konfiguriert ist, um das Wiederholungssignal unter Verwendung einer Abtastrate in digitale Abtastwerte umzuwandeln,
    - einen numerisch gesteuerten Oszillator (28) und eine Mischstufe (30), wobei der numerisch gesteuerte Oszillator (28) und die Mischstufe (30) gemeinsam konfiguriert sind, um die Frequenz der Abtastwerte zu verschieben,
    - eine periodische Mittelungsschaltung (38), die dem numerisch gesteuerten Oszillator (28) und der Mischstufe (30) nachgeschaltet ist, wobei die periodische Mittelungsschaltung (38) konfiguriert ist, um die Abtastwerte, die über eine definierte Anzahl von Pufferlängen erhalten werden, zu summieren oder zu mitteln, wobei dadurch mindestens ein Ausgangssignal bereitgestellt wird, wobei die Pufferlänge aus der Wiederholungsfrequenz und der Abtastrate abgeleitet wird, wobei sich die Pufferlänge auf ein ganzzahliges Vielfaches der Periodenlänge des Wiederholungssignals bezieht,
    - eine Verarbeitungsschaltung (42), die konfiguriert ist, um eine FourierTransformation an dem mindestens einen Ausgangssignal durchzuführen, wobei dadurch das mindestens eine Ausgangssignal in den Frequenzbereich umgewandelt wird, und

    wobei der numerisch gesteuerte Oszillator (28) zusammen mit der Mischstufe (30) konfiguriert ist, um die Frequenz der Abtastungen derart zu verschieben, dass Picket-Signalabschnitte des mindestens einen Ausgangssignals, nämlich die Abtastungen, die in dem Ausgangssignal enthalten sind, das durch die periodischen Mittelungsschaltung (38) bereitgestellt wird, auf eine Zwischenfrequenz (IF) von Null verschoben werden, wobei dadurch sichergestellt wird, dass die Picket-Signalabschnitte, die durch die Verarbeitungsschaltung (42) verarbeitet werden, Frequenzklassen in dem Frequenzbereich zugeordnet sind.

2.  Messsystem nach Anspruch 1, wobei die periodische Mittelungsschaltung (38) konfiguriert ist, um das mindestens eine Ausgangssignal in Echtzeit bereitzustellen und/oder eine IQ-Mittelung durchzuführen.

3.  Messsystem nach Anspruch 1 oder 2, wobei die periodische Mittelungsschaltung (38) durch ein feldprogrammierbares Gate-Array (FPGA) oder einen digitalen Signalprozessor (DSP) eingerichtet wird.

4.  Messsystem nach einem der vorstehenden Ansprüche, wobei das Messsystem (10) ferner einen fraktionalen Resampler (34) umfasst, der der periodischen Mittelungsschaltung (38) vorgeschaltet ist, wobei der fraktionale Resampler (34) konfiguriert ist, um eine ganzzahlige Anzahl von Abtastungen bereitzustellen, die einer Wiederholungslänge des Wiederholungssignals entspricht.

5.  Messsystem nach einem der vorstehenden Ansprüche, wobei das Messsystem (10) eine Frequenzreferenz (44) umfasst, die mit der Signalquelle (12) und dem Analog-Digital-Wandler (24) verbunden ist, wobei dadurch eine gemeinsame Frequenzreferenz für die Signalquelle (12) und den Analog-Digital-Wandler (24) bereitgestellt wird.

6.  Messsystem nach einem der vorstehenden Ansprüche, wobei bei einem freilaufenden System die Wiederholfrequenz und/oder die Abtastrate geschätzt werden, insbesondere wobei die geschätzte Wiederholfrequenz und/oder die geschätzte Abtastrate an den fraktionalen Resampler (34) weitergegeben wird/werden.

7.  Messsystem nach einem der vorstehenden Ansprüche, wobei die periodische Mittelungsschaltung (38) konfiguriert ist, um die Anzahl der Mittelungen basierend auf einem Signal-Rausch-Verhältnis (SNR) und einer Auflösungsbandbreite (RBW) zu bestimmen.

8.  Messsystem nach einem der vorstehenden Ansprüche, wobei die periodische Mittelungsschaltung (38) konfiguriert ist, um mehrere gemittelte Signale auszugeben, insbesondere wobei die mehreren gemittelten Signale jeweils der definierten Anzahl von Pufferlängen zugeordnet sind.

9. Messsystem nach einem der vorstehenden Ansprüche, wobei das Messsystem (10) konfiguriert ist, um eine Gruppenverzögerung zu kompensieren und/oder wobei das Messsystem (10) konfiguriert ist, um insbesondere nach der Kompensation der Gruppenverzögerung erneut in Polarkoordinaten zu mitteln.

10. Messsystem nach einem der vorstehenden Ansprüche, wobei das Messsystem (10) eine Fensterschaltung umfasst, die konfiguriert ist, um eine Fenstermultiplikation mit einem bekannten Fenster durchzuführen, insbesondere wobei sich die Fensterschaltung entweder vor oder nach der periodischen Mittelungsschaltung (38) befindet.

11. Messsystem nach einem der vorstehenden Ansprüche, wobei das Messsystem (10) mehrere Kanäle umfasst, wobei das Messsystem (10) aktiviert ist, um die jeweiligen Frequenzantworten jedes der Signale zu bestimmen, die durch die verschiedenen Kanäle verarbeitet werden, und wobei das Messsystem (10) konfiguriert ist, um relative Frequenzantworten der Signale zu bestimmen, die durch die mehreren Kanäle verarbeitet werden.

12. Messsystem nach einem der vorstehenden Ansprüche, wobei das Messsystem (10) ein Entzerrermodul (48) umfasst, das konfiguriert ist, um für eine bestimmte Frequenzantwort einen kompensierenden digitalen Filter zu berechnen und den kompensierenden digitalen Filter anzuwenden.

13. Messsystem nach einem der vorstehenden Ansprüche, wobei das Messsystem (10) einen lokalen Oszillator (14) umfasst, wobei eine Versatzbestimmungsschaltung bereitgestellt ist, die konfiguriert ist, um einen Phasenversatz des lokalen Oszillators (14) in Bezug auf eine Startphase des Wiederholungssignals zu bestimmen, und wobei die Phase des lokalen Oszillators (14) korrigiert wird.

14. Messsystem nach einem der vorstehenden Ansprüche, wobei die Wiederholungsfrequenz eine geschätzte Wiederholungsfrequenz, die mittels eines Schätzermoduls (46) geschätzt wird, oder eine bekannte Wiederholungsfrequenz ist, die insbesondere aus einer Datenbank abgerufen oder durch einen Bediener des Messsystems eingegeben wird.

15. Messsystem nach einem der vorstehenden Ansprüche, wobei die Signalquelle durch die zu testende Vorrichtung selbst oder einen Kalibrierungssignalgenerator eingerichtet wird.

**Revendications**

1. Système de mesure pour la détermination d'une réponse en fréquence d'un dispositif à l'essai, dans lequel le système de mesure (10) comprend

   - une source de signal (12) qui est configurée pour fournir un signal répétitif avec une fréquence de répétition,
   - un convertisseur analogique-numérique (24) qui est configuré pour convertir le signal répétitif en échantillons numériques à l'aide d'un taux d'échantillonnage,
   - un oscillateur à commande numérique (28) et un étage de mélange (30), dans lequel l'oscillateur à commande numérique (28) et l'étage de mélange (30) sont configurés conjointement pour déplacer les échantillons en fréquence,
   - un circuit de moyennage périodique (38) qui est situé en aval de l'oscillateur à commande numérique (28) et de l'étage de mélange (30), dans lequel le circuit de moyennage périodique (38) est configuré pour additionner ou moyenner les échantillons obtenus sur un nombre défini de longueurs de tampon, fournissant de ce fait au moins un signal de sortie, dans lequel la longueur de tampon est tirée de la fréquence de répétition et du taux d'échantillonnage, dans lequel la longueur de tampon se rapporte à un multiple entier de la longueur de période du signal répétitif,
   - un circuit de traitement (42) qui est configuré pour effectuer une transformée de Fourier sur l'au moins un signal de sortie, convertissant de ce fait l'au moins un signal de sortie dans le domaine fréquentiel, et

   dans lequel l'oscillateur à commande numérique (28) conjointement à l'étage de mélange (30) sont configurés pour déplacer la fréquence des échantillons de telle sorte que des parties de signal de prélèvement de l'au moins un signal de sortie, à savoir les échantillons contenus dans le signal de sortie fourni par le circuit de moyennage périodique (38), sont déplacées à une fréquence intermédiaire (FI) de zéro, garantissant de ce fait que les parties de signal de prélèvement, traitées par le circuit de traitement (42), sont associées à des banques de fréquence dans le domaine fréquentiel.

2. Système de mesure selon la revendication 1, dans lequel le circuit de moyennage périodique (38) est configuré pour fournir l'au moins un signal de sortie en temps réel et/ou pour effectuer le moyennage IQ.

3. Système de mesure selon la revendication 1 ou 2, dans lequel le circuit de moyennage périodique (38) est établi par un réseau prédiffusé programmable par l'utilisateur (FPGA) ou un processeur de signal numérique (DSP).

4. Système de mesure selon l'une quelconque des revendications précédentes, dans lequel le système de mesure (10) comprend en outre un rééchantillonneur fractionnaire (34) qui est situé en amont du circuit de moyennage périodique (38), dans lequel le rééchantillonneur fractionnaire (34) est configuré pour fournir un nombre entier d'échantillons qui correspond à une longueur de répétition du signal répétitif.

5. Système de mesure selon l'une quelconque des revendications précédentes, dans lequel le système de mesure (10) comprend une référence de fréquence (44) qui est connectée à la source de signal (12) et au convertisseur analogique-numérique (24), fournissant de ce fait une référence de fréquence commune pour la source de signal (12) et le convertisseur analogique-numérique (24).

6. Système de mesure selon l'une quelconque des revendications précédentes, dans lequel, dans un système à fonctionnement libre, la fréquence de répétition et/ou le taux d'échantillonnage sont estimés, en particulier dans lequel la fréquence de répétition estimée et/ou le taux d'échantillonnage estimé est/sont transmis au rééchantillonneur fractionnaire (34).

7. Système de mesure selon l'une quelconque des revendications précédentes, dans lequel le circuit de moyennage périodique (38) est configuré pour déterminer un nombre de moyennes en fonction du rapport signal/bruit (SNR) et de la largeur de bande de résolution (RBW).

8. Système de mesure selon l'une quelconque des revendications précédentes, dans lequel le circuit de moyennage périodique (38) est configuré pour émettre plusieurs signaux moyennés, en particulier dans lequel les plusieurs signaux moyennés sont chacun associés au nombre défini de longueurs de tampon.

9. Système de mesure selon l'une quelconque des revendications précédentes, dans lequel le système de mesure (10) est configuré pour compenser le retard de groupe et/ou dans lequel le système de mesure (10) est configuré pour moyenner à nouveau en coordonnées polaires, notamment après la compensation de retard de groupe.

10. Système de mesure selon l'une quelconque des revendications précédentes, dans lequel le système de mesure (10) comprend un circuit de fenêtrage qui est configuré pour effectuer une multiplication de fenêtrage avec une fenêtre connue, en particulier dans lequel le circuit de fenêtrage est situé soit avant soit après le circuit de moyennage périodique (38).

11. Système de mesure selon l'une quelconque des revendications précédentes, dans lequel le système de mesure (10) comprend de multiples canaux, dans lequel le système de mesure (10) est capable de déterminer les réponses en fréquence respectives de chacun des signaux traités par les différents canaux, et dans lequel le système de mesure (10) est configuré pour déterminer des réponses en fréquence relatives des signaux traités par les multiples canaux.

12. Système de mesure selon l'une quelconque des revendications précédentes, dans lequel le système de mesure (10) comprend un module d'égalisation (48) qui est configuré pour calculer un filtre numérique de compensation pour une réponse en fréquence déterminée et pour appliquer le filtre numérique de compensation.

13. Système de mesure selon l'une quelconque des revendications précédentes, dans lequel le système de mesure (10) comprend un oscillateur local (14), dans lequel un circuit de détermination de décalage est fourni, qui est configuré pour déterminer un décalage de phase de l'oscillateur local (14) par rapport à une phase de départ du signal répétitif, et dans lequel la phase de l'oscillateur local (14) est corrigée.

14. Système de mesure selon l'une quelconque des revendications précédentes, dans lequel la fréquence de répétition est une fréquence de répétition estimée qui est estimée au moyen d'un module d'estimation (46) ou une fréquence de répétition connue, notamment extraite d'une base de données ou introduite par un opérateur du système de mesure.

15. Système de mesure selon l'une quelconque des revendications précédentes, dans lequel la source de signal est établie par le dispositif à l'essai lui-même ou un générateur de signal d'étalonnage.

Fig. 1

Fig. 2

EP 4 119 954 B1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20120020397 A1
- EP 0841569 A2

- US 20050213689 A1